# EUROPEAN PATENT APPLICATION

(11) **EP 0 607 684 A2**
(43) Date of publication of application: **27.07.1994**
(21) Application number: 93310123.0
(22) Date of filing: 15.12.1993
(51) Int. Cl.: H01L 21/3105, H01L 21/311

(54) **Elimination of local loading effect in dielectric planarization**

(30) Priority: 31.12.1992 US 999327
(71) Applicant: AT&T Corp., New York, NY 10013-2412 (US)
(72) Inventor: Alugbin, Dayo, Bethlehem, Northampton 18017 (US); Olasupo, Kolawole Rahman, Kutztown, Berks 19530 (US); Kornblit, Avinoam, Highland Park, Middlesex 08904 (US); Martin, Edward Paul, Bethlehem, Northampton 18017 (US)
(74) Representative: Johnston, Kenneth Graham

(57) **Abstract**

Local loading effects are reduced in a planarizing etchback of a dielectric layer by using a plasma comprising SF₆.

## Description

### Technical Field

This invention relates to a method of integrated circuit manufacturing which includes a dielectric planarization step.

### Background of the Invention

Integrated circuits frequently require patterning of a dielectric layer to form windows which expose selected portions of the underlying material. The dielectric layer is frequently deposited on a surface that has features; that is, a nonplanar surface. The features may be, for example, interconnects, gate structures, tub steps or field oxides. The patterning deposits a layer of photoresist or polymer and then exposes selected portions of the photoresist to radiation to form an image in the resist. Well known and conventional techniques are then used to transfer the image from the resist into and through the dielectric layer.

While this process is conceptually simple, implementation may lead to difficulties. For example, a nonplanar dielectric surface may make accurate lithographic patterning difficult due to limited depth of focus. Nonplanarized surfaces may also lead to difficulties in etching layers deposited on the nonplanar surface. The dielectric is frequently planarized to alleviate these problems. See, for example, Journal of the Electrochemical Society, 131, pp. 123- 125, January 1984_{"} and 128, pp. 423-428, February 1987. In order to obtain a planarized surface a dielectric thicker than the desired final thickness is deposited followed by deposition of thin polymer which has good planarization properties. Using either plasma or RIE techniques the polymer and part of the dielectric are removed. Frequently, the dielectric being planarized is silicon dioxide and mixtures of CHF₃, CF₄ or C₂F₆ with oxygen are used. The oxygen concentration is varied to match the etch rates of silicon dioxide and polymer. As the polymer is etched back and the oxide is exposed to the plasma, the total oxygen content in the plasma increases, at least locally, and the polymer around the isolated feature is etched at a higher rate than is the oxide. A nonplanarized dielectric surface results. This phenomenon is commonly referred to as "local loading." One attempt to avoid this phenomenon uses NF₃. However, this is a toxic gas and non-toxic alternatives are desirable.

### Summary of the Invention

According to an embodiment of this invention, the local loading effect in dielectric planarization is reduced by using fluorine, rather than oxygen, to control polymer erosion. This can be achieved by adding SF₆ to the plasma. The plasma has SF₆ and at least one other etchant. Features are formed on a surface thereby forming a nonplanar surface, a dielectric is deposited over the features, and a layer of polymer is then deposited over the dielectric. The dielectric planarization is then performed using the SF₆ containing plasma. The plasma desirably has a mixture of SF₆ and the other component selected so that the polymer and the dielectric etch at approximately the same rate. The process is terminated after the polymer clears. In an exemplary embodiment, the dielectric comprises an oxide such as TEOS. In a preferred embodiment, the plasma further comprises CHF₃. In another preferred embodiment, the plasma further comprises CF₄ or C2 F6. A minor amount of oxygen may be present in the plasma provided that the polymer etch rate does not vary strongly with the oxygen concentration.

### Brief Description of the Drawing

FIG. 1 is a sectional view of a portion of an integrated circuit fabricated according to this invention; and
FIG. 2 plots the etch rate vertically versus the SF₆ flow rate horizontally for exemplary photoresists and dielectric materials.

For reason of clarity, the elements depicted are not drawn to scale.

### Detailed Description

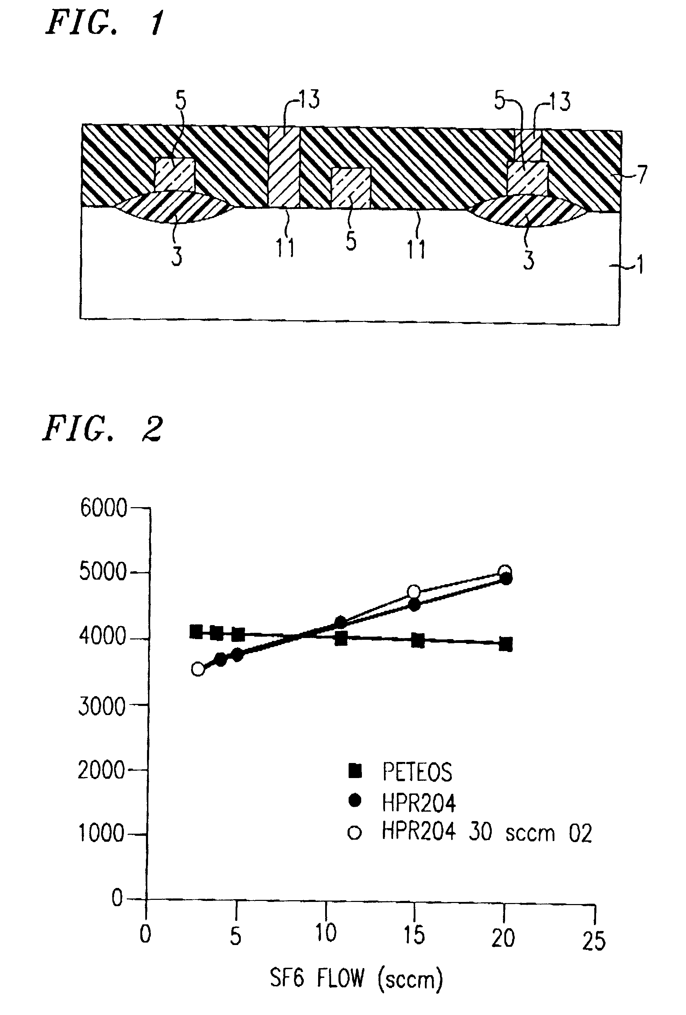

The invention will be described by reference to a particular embodiment after the window etch has been completed after dielectric planarization. Depicted in FIG. 1 are substrate 1, field oxide regions 3, interconnects 5, dielectric layer 7, and windows 9. The windows 9 are in dielectric layer 7 and expose selected portions of the substrate 1 or of the interconnects 5. Also depicted are source/drain regions 11 which are on opposite sides of an interconnect 5 which, in this case, is also a gate structure. Windows 9 have been filled with metal 13. It is readily apparent that the dielectric does not have a constant thickness, but that it does have a relatively planar surface. Local loading effects during the etchback that would have resulted in over- etching of the dielectric over the interconnect on the field oxide have been substantially reduced.

Conventional techniques are used, prior to the etchback, to fabricate the structure depicted. For example, the gate structure and interconnects will be easily fabricated as will the field oxides. Conventional ion implantation techniques can be used to form the source/drain regions. Well known materials can also be used. Well known techniques are used to deposit the dielectric layer 7. An exemplary dielectric is an oxide such as TEOS which may he deposited by a low pressure chemical vapor deposition or plasma enhanced process.

Due to the evident topography of the surface, the dielectric layer also has a nonplanar surface. It is desired to obtained a planar dielectric surface to facilitate subsequent processing. A polymer layer is then deposited and etched back to planarize the dielectric layer. The plasma has a mixture of SF₆ and at least one other etchant. Exemplary other etchants include CHF₃, C₂F₆ andCF₄ either with or without a small amount of oxygen. The ratio of the other etchant to SF₆ is important as will be appreciated from a consideration of FIG. 2 which plots the etch rate vertically in nm/minute versus the SF₆ flow rate horizontally in units of sccm (standard cubic centimeters/minute) with the flow of CHF₃ held constant. The etch rates for plasma enhanced TEOS and a HPR 204 photoresist are shown. As can be seen, there is an SF₆ flow rate for which the etch rates are approximately equal; good planarization with negligible local loading effect occurs at this point. Accordingly, the planarization etchback should be in a plasma with an SF₆ component selected so that the dielectric and the photoresist etch at approximately the same rate. Also shown in FIG. 2 is the etch rate of photoresist when oxygen was deliberately added to the plasma. If CHF₃ and 0₂ were the sole gases used for planarization, the resist etch rate would change significantly. In this case, however, the effect is negligible.

After the planarization has been completed, the windows 9 are formed and filled with metal 13. Conventional processing is then used to finish integrated circuit fabrication.

Variations in the embodiment described will be readily apparent to those skilled in the art.

## Claims

1. A method of integrated circuit fabrication comprising the steps of:
forming features on a surface thereby forming a nonplanar surface;
depositing a dielectric layer over said nonplanar surface;
depositing a layer of polymer over said dielectric layer;
planarizing said dielectric layer by etching back said polymer and said dielectric layer in a plasma comprising a mixture of SF₆ and at least one other etchant.

2. A method as recited in claim 1 in which said mixture is selected so that said polymer and said dielectric etch at approximately the same rate.

3. A method as recited in claim 1 in which said dielectric layer comprises an oxide.

4. A method as recited in claim 3 in which said oxide is TEOS.

5. A method as recited in claim 2 in which said at least one other etchant is CHF₃.

6. A method as recited in claim 2 in which said at least one other etchant is CF₄.

7. A method as recited in claim 5 in which said at least one other etchant is C₂ F₆ .

8. A method as recited in claims 5, 6, or 7 in which said plasma further comprises oxygen.
